Europäisches Patentamt

European Patent Office

Office européen des brevets

(19)

(11) EP 1 570 117 B1

(12) EUROPEAN PATENT SPECIFICATION

(45) Date of publication and mention
of the grant of the patent:
**02.08.2006 Bulletin 2006/31**

(51) Int Cl.:
*C30B 15/10* (2006.01)     *C30B 11/00* (2006.01)
*C30B 35/00* (2006.01)     *C04B 41/87* (2006.01)

(21) Application number: **02791784.8**

(22) Date of filing: **06.12.2002**

(86) International application number:
**PCT/EP2002/013850**

(87) International publication number:
**WO 2004/053207 (24.06.2004 Gazette 2004/26)**

(54) **VESSEL FOR HOLDING SILICON AND METHOD OF PRODUCING THE SAME**

BEHÄLTER FÜR SILICIUM UND VERFAHREN ZU SEINER HERSTELLUNG

RECIPIENT DESTINE A CONSERVER DU SILICIUM ET SON PROCEDE DE PRODUCTION

(84) Designated Contracting States:
**AT BE BG CH CY CZ DE DK EE ES FI FR GB GR
IE IT LI LU MC NL PT SE SI SK TR**
Designated Extension States:
**RO**

(43) Date of publication of application:
**07.09.2005 Bulletin 2005/36**

(73) Proprietor: **VESUVIUS FRANCE S.A.**
**59750 Feignies (FR)**

(72) Inventors:
• **SHIMIZU, Koichi**
  **Tokyo 108-0073 (JP)**
• **CAILLAUD, Frédéric**
  **F-59600 Maubeuge (FR)**
• **TANI, Kazumi**
  **Higashinada-ku, Kobe 658 (JP)**
• **KOBAYASHI, Yoshifumi**
  **higashinada-ku, Kobe 658 (JP)**

(74) Representative: **Debled, Thierry**
**Vesuvius Group S.A.**
**Intellectual Property Department**
**Rue de Douvrain, 17**
**7011 Ghlin (BE)**

(56) References cited:
**WO-A-98/35075          US-A- 4 356 152**

• **PATENT ABSTRACTS OF JAPAN vol. 2003, no.
06, 3 June 2003 (2003-06-03) & JP 2003 041357 A
(TOCALO CO LTD;VESUVIUS JAPAN KK;
VESUVIUS FRANCE SA), 13 February 2003
(2003-02-13)**
• **" ABSTRACTS + INDEXES, AMERICAN
CHEMICAL SOCIETY. COLUMBUS, US"
CHEMICAL ABSTRACTS + INDEXES, AMERICAN
CHEMICAL SOCIETY. COLUMBUS, US, vol. 105,
no. 4, 28 July 1986 (1986-07-28), XP000185916
ISSN: 0009-2258 & JP 61 048491 A 10 March 1986
(1986-03-10)**
• **HIDE ET AL.: "Mould shaping silicon crystal
growth with a mould coating material by the
spinning method" JOURNAL OF CRYSTAL
GROWTH., vol. 79, no. 1-3, December 1986
(1986-12), pages 583-589, XP002252583 NORTH-
HOLLAND PUBLISHING CO. AMSTERDAM., NL
ISSN: 0022-0248**
• **PRAKASH P ET AL: "USE OF SILICON
OXYNITRIDE AS A GRAPHITE MOLD RELEASING
COATING FOR THE GROWTH OF SHAPED
MULTICRYSTALLINE SILICON CRYSTALS"
JOURNAL OF CRYSTAL GROWTH, NORTH-
HOLLAND PUBLISHING CO. AMSTERDAM, NL,
vol. 144, no. 1/2, 1 November 1994 (1994-11-01),
pages 41-47, XP000484426 ISSN: 0022-0248**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**EP 1 570 117 B1**

**Description**

This invention relates to a vessel for melting silicon or a vessel for holding molten silicon and a method of producing the same.

The vessel according to the invention includes a mold made of sintered fused silica which is used for producing a semiconductor silicon wafer or a polycrystal silicon wafer for generating power from sunlight and for casting a silicon ingot, or a sintered fused silica crucible for melting, cleaning and further carrying silicon to a foundry, and moreover a vessel for holding a silicon bath until it is injected.

Hitherto, in the field of producing semiconductors, it is common to produce a silicon wafer as the base of a semiconductor element by solidifying a high purity silicon melt solution, forming a silicon monocrystal and slicing it. For example, a pure silicon material is melted by a heating resistance, a high frequency inductive heating device and the like, the silicon melt solution is then seeded with crystals. The solution is thoroughly mixed and then drawn up slowly and unidirectionally solidified to form a large cylindrical silicon monocrystal having preferred orientation of the seed crystal. In such a producing process, graphite, quartz, boron nitride and platinum are suitable materials for the vessel for melting and holding silicon, (i.e., the crucible).

Moreover, in case of producing amorphous silicon or polycrystal silicon for a solar cell, it is necessary to hold a very pure silicon melt solution within a vessel such as the above-described crucible.

As described above, however, when a crucible is used as a vessel for holding molten metal, the silicon melt solution is often contaminated with impurity metal components of the crucible walls contacting the molten bath, thereby reducing the purity of the silicon.

Further, with a background of offering cheap silicon and demanding productivity improvement in recent years, a cheap fused silicon oxide material (sintered or densified fused silica) has largely been used instead of quartz for the crucible, and measures to avoid the contamination of a silicon melt solution have been required.

In reply to such requirement, hitherto, as the measures to avoid the contamination of the silicon melt solution, there has been considered a method of applying a coating to the melt solution contact portion of a sintered silicon oxide material crucible so as to protect the silicon melt solution from direct contact with the crucible walls. I.e., the inside of the crucible wall is coated with a coating agent such as an oxide, a nitride and the like having an excellent releasability from molten silicon and an excellent wettability with the molten silicon (the more wettable is the coating, the less deep is the molten silicon penetration).

However, as the said coating agents (oxide, nitride) are hardly sintering by themselves, there are defects such as weak bond strength to the crucible wall and partial peeling. Further, the peeled coating agent is mixed into the molten silicon and forms new impurities, lowering again the purity of the product.

On the other hand, as a coating agent, use may be made of silicon nitride ($Si_3N_4$), which is well known as a material having excellent non-reactivity with molten silicon because it includes no metal element. However, silicon nitride is poor in sinterability and worse in productivity since shaping-sintering treatments such as hot press, HIP and the like are not available for bringing the mechanical strength up to a practical level. Further, there is a problem of large economical loss when applying the aforesaid treatments for a crucible which is regarded as expandable.

I.e., the higher the demand for purity, the higher the requirement for high performance of the chemical composition of the coating agent itself, the mechanical strength of a coating layer per se and the bonding strength to the crucible wall. Further, prior technique for applying the above coating layer is slow in film-forming rate and requires many layers to obtain a practical thickness. Therefore, it needs to be improved in terms of productivity and cost.

As described above, when a crucible, is used as a vessel, for producing a silicon wafer, it is necessary to protect the silicon melt solution from contamination with impurity from the crucible wall so as to obtain silicon of high purity. Therefore, heat-resistant coatings such as oxide, nitride and the like are often applied to the inner surface of the crucible to avoid any contamination, but as discussed above, these coating materials are generally poor in sinterability and low in mechanical strength, and requires to be improved in the light of productivity and economy.

A main object of the invention is therefore to solve the aforesaid problems of the prior art, that is, to provide a silicon molten bath holding vessel which will not contaminate the silicon melt solution together with excellent sinterability, mechanical strength and productivity.

Further, another object of the invention is to provide such sprayed coating forming technique, such that the silicon molten bath little reacts with the molten bath contact surface of the molten silicon holding vessel, erosion resistance is excellent against a flow in the molten bath, metal contamination is low, and an ingot of high quality and high yield can effectively be obtained.

The invention provides a silicon holding vessel as set forth in claim 1 basically made by coating a silicon composite thermet sprayed coating consisting of metal silicon, silicon nitride and silicon oxide on the interior of the silicon holding vessel. In such construction, the said silicon composite thermet sprayed coating plays a role of non-reactivity of a nitride against molten silicon, and shows good erosion resistance against a melt solution flow by mutually compounding a glass bonding phase of an oxide compounded with the nitride and a metal silicon bonding phase.

The said silicon composite thermet sprayed coating is formed by spraying a silicon composite thermet material made by adding metal silicon as a bonding agent to a mixture of $Si_3N_4$ and $SiO_2$. Further, the silicon holding vessel is made by using either one of silicon oxide, boron nitride and graphite, in which the silicon oxide ($SiO_2$) is preferably densified fused silica.

Further, the invention relates to a method of producing a silicon holding vessel as set forth in claim 6, which comprises spraying a silicon composite thermet material consisting of metal silicon, silicon nitride and silicon oxide on the interior of the silicon holding vessel, thereby forming a silicon composite thermet sprayed coating.

Moreover, in the invention, the said silicon holding vessel is preferably formed in a material comprising silicon oxide, boron nitride and/or graphite. The said sprayed coating is preferably coated and formed by any spraying process such as plasma spraying, high velocity gas flame spraying, gas powder spraying or detonation spraying.

Moreover, according to the invention, the above silicon composite thermet sprayed coating has a mixing ratio of metal silicon (X), silicon nitride (Y), silicon oxide (Z) of X:Y:Z = 20-50: 77-30: 3-20.

Brief description of the drawing

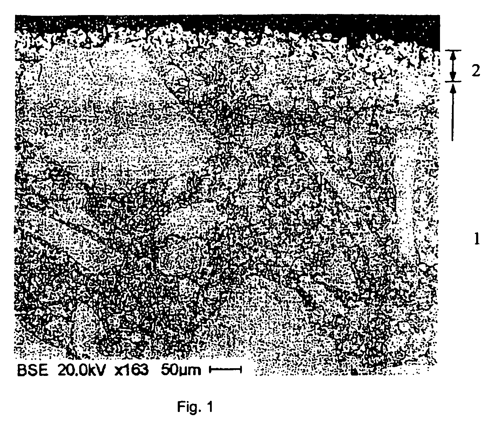

Fig. 1 is a photomicrography of the sectional structure of the composite sprayed coating of the invention.

The inventors have examined the sprayed coating of hardly sinterable silicon nitride for many years. As a result, the inventors ascertained that it is effective to use a silicon composite thermet material (mixed raw material) obtained by mixing silicon nitride with silicon oxide and metal silicon at a predetermined ratio. According to the preferred process of the invention, the surface of the vessel is first cleaned, the said silicon composite thermet material is then sprayed to form a silicon thermet sprayed coating, and thereafter optionally, if it is desirable to adjust the smoothness of the surface, the coated surface can be polished.

According to the prior art, in order to use $Si_3N_4$ as industrial material, it is necessary to form a layer by hot pressing or HIP, by adding a sintering aid. In case of forming a sprayed coating with the use of inorganic nonmetal material such as oxide, carbide, boride or nitride, an addition of metal as a binder is fundamental. According to the invention, however, as the object thereof is a vessel for melting and holding high purity silicon, it is considered to be inappropriate to use a metal different from the silicon. Therefore, since the high purity material to be treated is silicon, the invention uses high purity silicon as a binder.

Further, the invention adds a silicon oxide besides the use of metal silicon as a binder. The reason why silicon oxide is used in the invention is that a sprayed coating composite thermet including silicon nitride and oxide using metal silicon as a matrix (binder layer) is obtained by softening the silicon oxide ($SiO_2$) in a plasma flame during plasma spraying, envelopingly adhering at least part of $Si_3N_4$, further coveringly adhering both $Si_3N_4$ and $SiO_2$ to the said metal silicon and flying as fixing and making $Si_3N_4$ particles pseudo-particles. Such sprayed coating has a very high strength.

The above spraying material (raw material powder) is made by mixing metal silicon $(MSi)_x$, silicon nitride $(Si_3N_4)_y$ and silicon oxide $(SiO_2)_z$ at the following mixing ratio (capacity ratio)

$$X:Y:Z = 20\text{-}50: 77\text{-}30: 3\text{-}20.$$

At the above mixing ratio of each component, the reason why $(MSi)_x$ is limited to 20-50 is because an amount of less than 20 is not sufficient to work as a binder between oxide and nitride to obtain a coating strength, and as a result, it does not withstand erosion loss caused by moving contact with a melt solution. An amount of more than 50 provides large silicon metal zone in the coating, so that a diffuse reaction layer of the coating and the melt solution is formed until solidification of the melt solution, and, therefore, a layer containing impurities on the solidified product surface is formed. The preferable amount is 30-45.

Further, The reason why $(SiO_2)_x$ is limited to 3-20 is because when it is less than 3, binding strength between $Si_3N_4$ particles cannot be obtained, and when it is more than 20, the wettability of $Si_3N_4$ by the melt solution is prevented. The preferable amount is 7-13.

$(Si_3N_4)_y$ is determined by optimizing the amount of the above $(MSi)_x$ and $(SiO_2)_z$ taking into account the desired coating strength and melt solution wettability.

Further, it is preferable to use silica (densified fused silica) for $SiO_2$. As industrial $SiO_2$ material, there are fused silica as an opaque substance using silica sand as raw material and vitreous silica as a transparent substance produced by using crystal as raw material, both of which can be used in the present use as far as properties of matter are concerned. However, the reason why according to the invention the use of densified fused silica is preferable is because a densified fused silica product can be formed as required form by melting silica sand to obtain rough raw material consisting essentially of $SiO_2$, thereafter pulverizing to form fine particles, and further molding into a mold, and further sintering the mold to impart the mechanical strength necessary for the product. The product made with such densified fused silica material has excellent compatibility and sizability.

The above spraying material is sprayed on at least the surface of a part contacted with molten metal within a holding vessel in a thickness of about 20-500 $\mu$m, preferably 40-300 $\mu$m. The reason why the coating thickness is limited in this manner is because if the thickness is thinner than 20 $\mu$m, it is insufficient to form a coherent layer between thermet particles and there is the possibility for the melt solution to contact the crucible base material through gaps, while if the thickness is thicker than 500 $\mu$m, the risk of peeling the coating is increased.

Example

This example uses mixed powder of metal silicon and $SiO_2$ with $Si_3N_4$ having the following composition by spraying silicon composite thermet material as a coating layer formed on the surface of a silicon holding vessel.

Table 1

| Composition | |
| --- | --- |
| oxygen | under 0.2 mass % |
| carbon | under 0.2 mass % |
| chlorine | under 100 ppm |
| He | under 100 ppm |
| AlCa | traces |
| $Si_3N_4$ | the remaining |

There are used metal silicon of 99.9% purity and $SiO_2$ of 99.8% purity. The mixture ratio of these raw material powders is $Si:Si_3N_4:SiO_2$ = 40:50:10. Further, the mixed powder is converted into a thermal spray material by previously granulating into about 25,3 $\mu$m in mean particle diameter.

Fig. 1 shows the sectional structure of a composite sprayed coating according to the invention. The illustrated reference numeral 1 shows a densified fused silica base material and 2 a composite sprayed coating.

Example 1

In this example, the interaction between a densified fused silica base material covered with a silicon composite thermet sprayed coating and a silicon melt solution according to the invention is examined. As a probe, use is made of a densified fused silica base material of dimension: 100x50x6 mm. On the probe surface is sprayed a spraying material mixed at the ratio of $Si:Si_3N_4:SiO_2$ = 40:50: 10 in thickness of 300 $\mu$m by an atmospheric plasma spraying process to form a silicon composite thermet sprayed coating. The erosion resistant property of the coating due to melt solution falling and the influence of the melt solution contact are examined by laying such probe formed with the sprayed coating at the bottom of a crucible made of densified fused silica of 350x350x400 (h)mm in size and injecting a silicon melt solution from the upper part. The crucible is heated from the outside with the use of an electric heater and held in the molten state of the silicon melt solution for 3 hours.

After 3 hours, the specimen is taken out of the crucible and the surface is observed. Within a visual observation, no peeling from the coating base material is recognized and, good bondability and non-reactivity are shown. Further, there is found no influence of the melt solution on the coating.

Example 2

In this example is formed a silicon composite sprayed coating according to the invention on the interior of a polycrystalline silicon ingot cast mold in order to produce a solar cell polycrystalline silicon wafer used for sunlight power generation. The mold used is made of densified or sintered fused silica containing $Al_2O_3$:2000 ppm and $Fe_2O_3$:200 ppm, and its dimension is 350x350x400 (h)mm. On the bottom of the mold is sprayed a spraying material powder raised at the capacity ratio of $Si:Si_3N_4:SiO_2$ = 40:50:10 in thickness of 50-70 $\mu$m by an atmospheric plasma spraying process to form a silicon composite thermet sprayed coating.

As a comparative example, there is used a coating formed by slurrying $Si_3N_4$ powder with the use of polyvinyl alcohol as a solvent, brushing the resulting slurry on the mold base or applying by a spraying process and firing at 900°C.

Table 2 shows a result after examining contamination due to different kinds or materials at the surface layer portion of a silicon ingot product after casting.
Table 2

| | Crucible | Different material detected | |
|---|---|---|---|
| | Coating Material | Component | Depth from ingot surface layer |
| Example of the invention | $Si_3N_4/SiO_2/Si$ plasma sprayed film (50-70 $\mu$m) | $SiO_2$ | several $\mu$m |
| Comparative example | Applied fired coating of $Si_3N_4$ slurry (500-1500 $\mu$m) | $Si_3N_4$, $Al_2O_3$, $SiO_2$, $Fe_2O_3$ | several 100 $\mu$m |

As is clear from the result of table 2, in the example of the invention, the different material detected in the silicon ingot surface layer is $SiO_2$ only. Further, the penetrated depth from the surface layer is several $\mu$m. This $SiO_2$ is due to atmospheric oxidation of Si. Therefore, this $SiO_2$ can completely be removed by bevel cutting at not more than 2mm. As a result, the ingot yield is not less than 98%.

On the contrary, in comparative example, besides $Si_3N_4$, $Al_2O_3$, $SiO_2$, $Fe_2O_3$ and the like are further detected on the surface layer. Particularly, as metal elements, A1 and Fe are observed, and the penetrated depth from the surface layer of the different material is several 100 $\mu$m. In order to remove these different materials detected on the surface layer, it is necessary to bevel cut both sides in thickness of 10 mm, and the yield of a product ingot as low as about 94%.

According to the invention as explained above, in a crucible for casting metal silicon required to be highly pure, on the molten bath contact surface of the crucible is sprayed silicon composite thermet spraying material consisting of $Si/Si_3N_4/SiO_2$, thereby forming a coating to prevent the densified fused silica crucible from direct contact with the melt solution, to dissolve contamination due to crucible material and to form a strong releasable functional layer as compared with the hitheto used $Si_3N_4$ single coated layer. As a result, it can be possible to aim at the product yield improvement of a highly pure silicon ingot.

**Claims**

1. Vessel for receiving or melting molten silicon comprising a silicon composite thermet sprayed coating comprising metal silicon, silicon nitride and silicon oxide on at least a part of the interior wall of the silicon holding vessel, **characterized in that** the silicon composite thermet sprayed coating has a mixing ratio of metal silicon (X): silicon nitride (Y): silicon oxide (Z) of X:Y:Z: = 20-50: 77-30: 3-20.

2. A vessel according to claim 1, **characterized in that** the silicon composite thermet sprayed coating is formed by spraying a silicon composite thermet material made by adding metal silicon as a bonding material to a mixture of $Si_3N_4$ and $SiO_2$.

3. A vessel according to claim 1 or 2, **characterized in that** the silicon holding vessel is made from a material comprising silicon oxide, boron nitride and/or graphite.

4. A vessel according to claim 3, wherein the silicon oxide ($SiO_2$) is densified or sintered fused silica.

5. A vessel according to claim 1, **characterized in that** the coating has a thickness of 20-500 $\mu$m, preferably of 50-300 $\mu$m.

6. A method of producing a vessel for receiving or melting molten silicon, which comprises spraying a silicon composite thermet material consisting of metal silicon, silicon nitride and silicon oxide on the interior wall of said vessel, thereby forming a silicon composite thermet sprayed coating wherein the silicon thermet sprayed coating has a mixing ratio of metal silicon (X): silicon nitride (Y): silicon oxide (Z) of X:Y:Z: = 20-50: 77-30: 3-20.

7. A method according to claim 6, wherein said vessel is made from a material comprising silicon oxide, boron nitride and/or graphite, preferably densified or sintered fused silica.

**EP 1 570 117 B1**

**Patentansprüche**

1. Gefäß zum Aufnehmen oder Schmelzen von geschmolzenem Silizium, das eine auf mindestens einem Teil der Innenwand des Siliziumhaltegefäßes aufgesprühte Beschichtung aus Silizium-Verbund-Thermet umfasst, welche Siliziummetall, Siliziumnitrid und Siliziumoxid umfasst, **dadurch gekennzeichnet, dass** die aufgesprühte Beschichtung aus Silizium-Verbund-Thermet ein Mischungsverhältnis von Siliziummetall (X): Siliziumnitrid (Y): Siliziumoxid (Z) von X:Y:Z = 20-50:77-30:3-20 aufweist.

2. Gefäß nach Anspruch 1, **dadurch gekennzeichnet, dass** die aufgesprühte Beschichtung aus Silizium-Verbund-Thermet durch Aufsprühen eines Silizium-Verbund-Thermet-Materials, das durch Zusetzen von Siliziummetall als Haftmaterial zu einem Gemisch von $Si_3N_4$ und $SiO_2$ hergestellt wird, gebildet wird.

3. Gefäß nach Anspruch 1 oder 2, **dadurch gekennzeichnet, dass** das Siliziumhaltegefäß aus einem Material hergestellt ist, das Siliziumoxid, Bornitrid und/oder Graphit umfasst.

4. Gefäß nach Anspruch 3, wobei das Siliziumoxid ($SiO_2$) verdichtetes oder gesintertes geschmolzenes Siliziumdioxid ist.

5. Gefäß nach Anspruch 1, **dadurch gekennzeichnet, dass** die Beschichtung eine Dicke von 20 bis 500 $\mu$m, vorzugsweise 50 bis 300 $\mu$m, aufweist.

6. Verfahren zur Herstellung eines Gefäßes zum Aufnehmen oder Schmelzen von geschmolzenem Silizium, das Aufsprühen eines Silizium-Verbund-Thermet-Materials, bestehend aus Siliziummetall, Siliziumnitrid und Siliziumoxid, auf die Innenwand des Gefäßes umfasst, wodurch eine aufgesprühte Beschichtung aus Silizium-Verbund-Thermet gebildet wird, wobei die aufgesprühte Beschichtung aus Silizium-Thermet ein Mischungsverhältnis von Siliziummetall (X):Silizsumnitrid (X):Siliziumoxid (Z) von X:Y:Z = 20-50:77-30:3-20 aufweist.

7. Verfahren nach Anspruch 6, wobei das Gefäß aus einem Siliziumoxid, Bornitrid und/oder Graphit, vorzugsweise verdichtetem oder gesintertem geschmolzenem Siliziumdioxid, hergestellt ist.

**Revendications**

1. Récipient pour recevoir ou pour fondre du silicium liquide comprenant un revêtement pulvérisé en thermet composite de silicium comprenant du silicium métallique, du nitrure de silicium et de l'oxyde de silicium sur au moins une partie de la paroi interne du récipient pour contenir du silicium, **caractérisé en ce que** le revêtement pulvérisé en thermet composite de silicium possède un rapport de mélange du silicium métallique (X): nitrure de silicium (Y): oxyde de silicium (Z) de X:Y:Z = 20-50:77-30:3-20.

2. Récipient selon la revendication 1, **caractérisé en ce que** le revêtement pulvérisé en thermet composite de silicium est formé en pulvérisant un matériau en thermet composite de silicium fait en ajoutant du silicium métallique en tant que matériau de liaison à un mélange de $Si_3N_4$ et de $SiO_2$.

3. Récipient selon la revendication 1 ou 2, **caractérisé en ce que** le récipient pour contenir du silicium est fait à partir d'un matériau comprenant de l'oxyde de silicium, du nitrure de bore et/ou du graphite.

4. Récipient selon la revendication 3 où l'oxyde de silicium (SiO2) est de la silice fondue densifiée ou sintérisée.

5. Récipient selon la revendication 1, **caractérisé en ce que** le revêtement a une épaisseur de 20-500 $\mu$m, de préférence, de 50-300 $\mu$m.

6. Méthode pour produire un récipient pour recevoir ou pour fondre du silicium fondu qui comprend la pulvérisation d'un matériau en thermet composite de silicium consistant en du silicium métallique, du nitrure de silicium et de l'oxyde de silicium sur la paroi interne dudit récipient formant ainsi un revêtement pulvérisé en thermet composite de silicium où le revêtement pulvérisé en thermet composite de silicium possède un rapport de mélange du silicium métallique (X): nitrure de silicium (Y): oxyde de silicium (Z) de X:Y:Z = 20-50:77-30:3-20.

7. Méthode selon la revendication 6, où ledit récipient est réalisé à partir d'un matériau comprenant de l'oxyde de silicium, du nitrure de bore et/ou du graphite, de préférence, de la silice fondue densifiée ou sintérisée.

BSE 20.0kV x163 50µm ⊢——⊣

Fig. 1